# EUROPÄISCHE PATENTSCHRIFT

(11) **EP 1 503 966 B1**
(45) Veröffentlichungstag und Bekanntmachung des Hinweises auf die Patenterteilung: **25.04.2007**
(21) Anmeldenummer: 03732220.3
(22) Anmeldetag: 30.04.2003
(51) Int. Cl.: C03C 17/00, C03C 17/245, C23C 14/08, C23C 14/58

(54) **BAUTEILE MIT KRISTALLINEN BESCHICHTUNGEN DES SYSTEMS ALUMINIUMOXID/SILIZIUMOXID UND VERFAHREN ZU DEREN HERSTELLUNG**
COMPONENTS HAVING CRYSTALLINE COATINGS OF THE ALUMINUM OXIDE/SILICON OXIDE SYSTEM AND METHOD FOR THE PRODUCTION THEREOF
COMPOSANTS POURVUS DE REVETEMENTS CRISTALLINS CONSTITUES DU SYSTEME OXYDE D'ALUMINIUM/OXYDE DE SILICIUM, ET LEUR PROCEDE DE PRODUCTION

(30) Priorität: 02.05.2002 DE 10219812
(43) Veröffentlichungstag der Anmeldung: 09.02.2005
(73) Patentinhaber: Technische Universität Dresden, 01062 Dresden (DE)
(72) Erfinder: MEYER, Dirk, 01326 Dresden (DE); LEVIN, Alexandr, 01069 Dresden (DE); PAUFLER, Peter, 01157 Dresden (DE)
(74) Vertreter: Uhlemann, Henry
(86) Internationale Anmeldenummer: PCT/DE2003/001440
(87) Internationale Veröffentlichungsnummer: WO 2003/093184

(56) Entgegenhaltungen:
- DE-A- 3 403 378
- DE-A- 10 012 316
- GB-A- 1 556 193
- US-A- 4 047 067

## Beschreibung

Die Erfindung betrifft Bauteile mit kristallinen Beschichtungen des Systems Aluminiumoxid/ Siliziumoxid und Verfahren zu deren Herstellung zur Erzeugung harter Schichten auf Silizium oder Silikatglasunterlagen als Material für harte und chemisch resistente Hochtemperaturbeschichtungen. Ausgezeichnete Hafteigenschaften resultieren aus der Verwachsung der Schichten mit den Unterlagen, die durch das Vorliegen von ausgedehnten Struktur- und/oder Konzentrationsgradienten insbesondere im Grenzflächenbereich gekennzeichnet ist.

Aluminiumoxid und Siliziumoxid sind aufgrund ihrer Eigenschaften auch als Materialien für Beschichtungen interessant. Dabei sind neben der für einzelne kristalline Modifikationen erreichbaren hohen Härte auch die optischen Eigenschaften entscheidend. Während Siliziumdioxid das wichtigste Grundmaterial für die Herstellung refraktiver Optiken bildet (sowohl glasartig als auch im kristallinen Zustand), können durch die Aufbringung von dünnen Aluminiumoxid-Schichten auf diesen Optiken beispielsweise Laser-Anti-Reflexschichten oder, durch Kombination mit SiliziumoxidSchichten, dielektrische Filter für den ausgedehnten Wellenlängenbereich von 0.3-5.0 µm realisiert werden, die bei sehr hohen Leistungsdichten ohne Zerstörung einsetzbar sind.

Kristallines Aluminiumoxid kommt beispielsweise in einer technisch besonders interessanten Modifikation als Korund (α-Aluminiumoxid) vor. Korund ist vor allem wegen seiner großen Härte (Mohshärte 9, zur einfachen Härtebestimmung nach Mohs sowie a. Verfahren s. z.B. F. Kohlrausch, *Praktische Physik* Band 1, B.G. Teubner, Stuttgart, 1968, S. 175 ff.) aber auch aufgrund seiner chemischen Indifferenz und seines hohen Schmelzpunktes ein hochgeschätzter Werkstoff. Natürlicher Korund ist nach Diamant das zweithärteste bekannte natürliche Mineral. Eine weitere Modifikation ist das γ-Aluminiumoxid, das eine Spinell-Struktur mit Fehlstellen aufweist und vergleichsweise weniger kompakt ist. Natürliche Aluminumoxid-Schutzschichten auf metallischem Aluminium weisen zumeist eine NaCl-Stsuktur mit Fehlstellen auf.

Kristallines Siliziumoxid kommt beispielsweise in den Modifikationen Quarz, Cristobalit oder Tridymit vor, die temperaturabhängig ineinander überführt werden können. Für technische Anwendungen ist allerdings häufig glasartiges Material auf Siliziumoxid-Basis von Interesse, d.h. die Bildung einer der kristallinen Modifikationen soll dann vermieden werden. Glasartige Materialien auf der Grundlage von Siliziumoxid können beispielsweise durch die Beimengung von Natriumoxid zur Schmelze erlangt werden.

DE 100 12 316 A1 beinhaltet ein Verfahren zur Beschichtung von Quarzbauteilen mit einer fest anhaftenden Schicht aus Aluminiumoxid als Schutz gegen chemische Reaktionen. Für die Beschichtung der Quarzbauteile ist dabei entweder die Aufbringung der Schutzschicht durch physikalische Abscheidung aus der Dampfphase oder durch chemische Abscheidung aus der Gasphase oder durch Aufbringung einer Aluminiumschicht und folgende Nachoxidation (unter Atmosphärenbedingungen 15 min bei 800°C) vorgesehen. Auf die Ausbildung einer definierten Modifikation der Kristallstruktur ist DE 100 12 316 A1 nicht ausgerichtet.

Bei der Aufbringung von Schichten auf Unterlagen oder infolge später wirkender Einflüsse kann es an der Grenzfläche zu Festkörperreaktionen kommen, die nach einer Durchmischung die Ausbildung anderer kristalliner Phasen ermöglichen. Im System Silizium/ Aluminium/ Sauerstoff sind ebenfalls verschiedene Modifikationen der Struktur des kristallinen Zustandes bekannt. Für die Al₂SiO₅-Gruppe sind die drei Modifikationen Cyanit, Andalusit und Sillimanit gesichert bekannt. Bei natürlichen Vorkommen kann aus der vorliegenden Modifikation auf den bei der Bildung wirksam gewesenen Druck geschlossen werden. Während der trikline Cyanit richtungsabhängige Mohshärten von 4-7 aufweist, erreichen die rhombischen Modifikationen Andalusit und Sillimanit Werte von 7.5 bzw. 6-7 nach Mohs. Damit sind im Sinne obiger Darstellung auch Schichten aus der Al₂SiO₅ - Gruppe als mechanische Schutzschichten (mit ebenfalls vielseitig technisch nutzbaren optischen Eigenschaften) interessant.

Werden Festkörper der Al₂SiO₅-Gruppe bzw. aus Kombinationen von Aluminiumoxid und Siliziumoxid auf hinreichend hohe Temperaturen (zumeist >1000°C) erwärmt, kann es zur Bildung von Mullit kommen. Aufgrund der ebenfalls hohen Härte (bis zu 7.5 nach Mohs), der großen Hitzebeständigkeit aber vor allem auch der hohen Widerstandsfähigkeit gegen chemische und physikalische Erosion hat Mullit große Bedeutung als feuerfester Werkstoff für chemische Reaktoren und Hochtemperaturöfen.

Es ist bekannt, daß bei Raumtemperatur amorph vorliegendes Aluminiumoxid durch eine geeignete Wärmebehandlung in kristalline Modifikationen überführt werden kann. Wird die Temperatur dabei in einem entsprechenden Regime langsam oder gestuft gesteigert, wird häufig bei Temperaturen in der Größe von ca. 1000°C als erste kristalline Phase γ-Aluminiumoxid beobachtet, welche dann nach ausgedehnter Wärmebehandlung bei dieser Temperatur, schneller aber bei höheren Temperaturen bis ca. 1200°C auch in α-Aluminiumoxid umwandeln kann (z. z.B. *T.C. Chou, D. Adamson, J. Mardinly and T.G. Nieh, Thin Solid Films, 205 (1991) 131-139;* leider finden sich dort keine Angaben zu den Druckbedingungen/ der Gaszusammensetzung der Atmosphäre während der Wärmebehandlung). Werden amorphe Aluminiumoxid-Schichten auf Saphir-Substraten derart behandelt, kann die Kristallisation ausgehend vom kristallinen Substrat unterstützt durch die somit vorgegeben Strukturinformation durch Festphasen-Epitaxie gelingen (s. z.B. *T.W. Simpson, Q. Wen, N. Yu and D.R. Clarke, J. Am. Ceram. Soc., 81(1) (1998) 61-66*). Für technische Anwendungen ist dagegen im allgemeinen die Erzeugung einkristalliner oder texturierter Schichten (polylaistalliner Schichten mit Vorzugsorientierung der Kristallite) aus Aluminiumoxid auf Unterlagen aus anderem Material erforderlich.

Die Aufgabe der Erfindung besteht in der Bereitstellung von Bauteilen mit einer harten und chemisch resistenten Beschichtung des Systems Aluminiumoxid/ Siliziumoxid mit hoher Haftung sowie einem Verfahren dafür.

Erfindungsgemäß wird die Aufgabe durch Bauteile mit kristallinen Beschichtungen des Systems Aluminiumoxid/ Siliziumoxid gelöst, bei denen die kristalline Aluminiumsilikatbeschichtung mit der Unterlage aus Silizium oder Silikatglas verwachsen ist und eine Durchmischungszone mit einem Konzentrations- und/oder Strukturgradienten aufweist.

Erfindungsgemäß wird die kristalline Beschichtung des Systems Aluminiumoxid/Siliziumoxid so erhalten, daß bei oder nach der Aufbringung von Aluminiumoxid Schichten auf Unterlagen bzw. Substraten aus Silizium oder Silikatglas eine Wärmebehandlung unter Vakuumbedingungen bei Temperaturen größer 1100 °C erfolgt. Vorzugsweise erfolgt die Wärmebehandlung bei einem Druck kleiner 5x10³ Pa.

Das erfindungsgemäße Verfahren ermöglicht die Ausbildung kristalliner Modifikationen des Systems Aluminium/ Silizium/ Sauerstoff durch Reaktion der Schicht mit Teilen der Unterlage. Die Unterlage stellt dabei Silizium bzw. Siliziumoxid (an Luft gelagertes Silizium bildet natürliche Siliziumoxidschichten, deren Dicke durch thermische Oxidation z.B. bis in den Mikrometerbereich ausgedehnt werden kann) für die Bildung von kristallinen Modifikation der Al₂SiO₅-Gruppe bzw. einer Mullitisation bereit.

Das erfindungsgemäße Verfahren führt zu einer Struktur aus einer i.a. thermisch stimulierten Festkörperreaktion zwischen Aluminiumoxid und der Unterlage. Die damit gleichzeitig erzielte Verwachsung der Schichten mit den Unterlagen, die durch das Vorliegen von ausgedehnten Struktur- und Konzentrationsgradienten insbesondere im Grenzflächenbereich gekennzeichnet ist, ergibt sehr vorteilhafte Haftungseigenschaften, die bei verschiedensten Belastungen erhalten bleiben.

Ein Konzentrationsgradient entsteht dabei durch die Inter-Diffusion der Komponenten der Aluminiumoxidschicht und der Unterlage. Dabei kann bei gegebenen Randbedingungen der Transport einzelner Komponenten bevorzugt sein. Da die Bildung der einzelnen kristallinen Modifikationen neben der Aktivierungsenergie, die hier vor allem durch die Prozeßtemperatur bereitgestellt wird, bestimmte chemische Zusammensetzungen (zumeist innerhalb bestimmter Intervalle) erfordert, kann für das vorliegende Verfahren der Konzentrationsgradient auch einen Strukturgradienten bedingen. Vorteil solcher Strukturgradienten ist der sukzessive Übergang zwischen zwei Festkörpern mit unterschiedlicher Kristallstruktur (hierbei kann von einer Komponente auch aus einer amorphen Struktur gestartet werden). Für abrupte Übergänge ist das Haftvermögen zumeist deutlich geringer, da dort der Einfluß der Fehlpassung beider Kristallstrukturen bzw. die eingeschränkte Varianz der Bindungsmöglichkeiten nachteilig wirkt. Darüber hinaus können z.B. unterschiedliche thermische Ausdehnungskoeffizienten von Schicht und Unterlage bei Temperaturwechsel in der technischen Nutzung zu einem Abplatzen der Schicht führen.

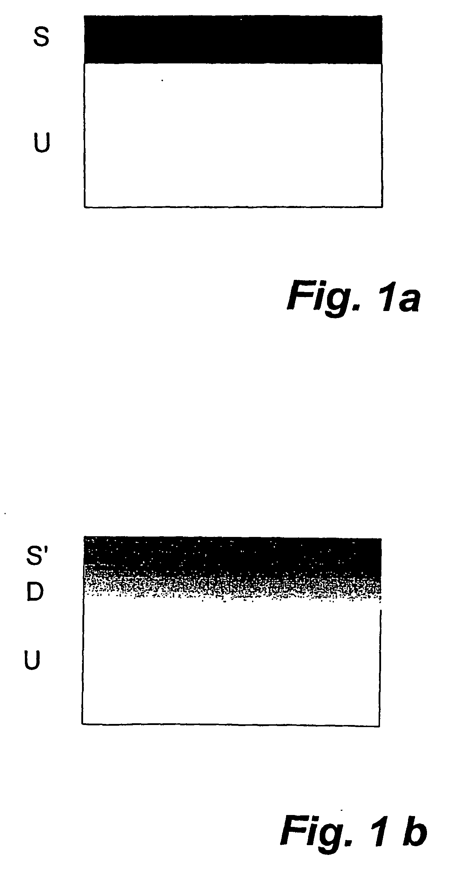

Anhand Fig. 1a und 1b wird die Erfindung näher erläutert. Auf einer Unterlage (U) aus Silikatglas wird in einem ersten Prozeßschritt eine Schicht (S) aus Aluminiumoxid abgeschieden, wobei nach Fig. 1a eine scharfe Grenzfläche (U)-(S) entsteht (Ausbildung einer zu vernachlässigenden Durchmischungszone abhängig vom verwendeten Verfahren in der Größe von < 1nm). Nach einer erfindungsgemäßen Temperaturbehandlung in einem zweiten Prozeßschritt bildet sich nach Fig. 1b eine ausgedehnte Durchmischungszone (D) der betreffenden Komponenten aus, wobei Teile der Unterlage (U) und die gesamte Schicht betroffen sein können.

Unter den erfindungsgemäßen Prozeßbedingungen erhält man neben dem Konzentrationsgradienten einen Strukturgradienten ausgehend von der Unterlage (diese kann amorph sein) durch die neue Schicht (S', bis zur Einstellung der gewünschten kristallinen Modifikation für die für die angestrebten Eigenschaften hinreichend ausgedehnten Volumenbereiche).

Die Erfindung umfaßt auch die Möglichkeit der Einstellung der erforderlichen Parameter während der Aufbringung der Schichten bzw. im unmittelbaren Anschluß daran. Dafür kann z.B. eine während der Abscheidung der Schichten wirksame Substratheizung eingesetzt werden.

Das erfindungsgemäße Verfahren kann auch als Nachbehandlung von Schichten realisiert werden. Dadurch kann für die Abscheidung der primären Aluminiumoxidschichten auf preiswerte großtechnisch umgesetzte Verfahren mit hoher Prozeßgeschwindigkeit zurückgegriffen werden, da zunächst das Aluminium oder Aluminiumoxid lediglich auf der Unterlage deponiert werden muß (Aluminium kann über die natürliche Oxidschichtbildung an Luft hinausgehend einfach thermisch oxidiert werden, weshalb nachfolgend verallgemeinernd Aluminiumoxid an dieser Stelle der Vorbehandlung benannt wird). Mit dem erfindungsgemäßen Verfahren gelingt es, gezielt die gewünschten strukturellen Modifikationen auch auf glasartigen Unterlagen zu erzeugen, ohne daß die erforderliche Prozeßtemperatur die Entglasungstemperatur wichtiger Silikatgläser übersteigt, womit diese Unterlagen im Hinblick auf ihre physikalischen Eigenschaften unverändert bleiben.

In einer vorteilhaften Ausgestaltung kann die Erwärmung der Aluminiumoxid-Schichten sowie der Bereiche vorrangig an der Grenzfläche zwischen Schicht und Substrat sowie angrenzender Substratbereiche durch die Absorption von elektromagnetischer Strahlung mit Wellenlängen der Strahlung im Ultraviolett-Bereich erfolgen. Die Lokalisierung der intensiv erwärmten Zone auf diesen Bereich gelingt für die meisten Silikatgläser, da der Absorptionsgrad für elektromagnetische Strahlung in diesem Wellenlängenbereich für Aluminiumoxid wesentlich größer als für diese Gläser ist. Zusätzlich kann durch streifenden Einfall der Strahlung bezüglich der Schichtoberfläche der Gesamtabsorptionsgrad zugunsten der Schicht weiter erhöht werden. Diese Form der gezielten lokalen Erwärmung ermöglicht auch die erfindungsgemäße Beschichtung von Silikatgläsern mit niedrigerer Entglasungstemperatur.

Als elektromagnetische Strahlung wird vorzugsweise Laserstrahlung mit einer Wellenlänge im UV-Bereich eingesetzt. Vorteilhaft wird die Laserstrahlung streifend, nahezu parallel zur Substratoberfläche eingestrahlt und damit die Eindringtiefe in das Substrat limitiert.

Erfindungsgemäß wird eine harte und kratzfeste Beschichtung auf optischen Gläsern (z.B. in optischen Linsen und Spiegeln) erhalten, die auch bei größeren Temperaturschwankungen (z.B. infolge Absorption bestimmter Spektralanteile des Lichtes bei diskontinuierlichem Betrieb) stabil bleibt.

Anhand nachfolgender Ausführungsbeispiele wird die Erfindung näher erläutert.

### Ausführungsbeispiel 1:

Auf einkristallinen Silizium-Substraten mit natürlicher Oxidschicht wird mittels Elektronenstrahlverdampfung Aluminiumoxid aufgedampft (Schichtdicken ca. 70 nm). Die so beschichteten Ausgangssubstrate werden anschließend einer Temperaturbehandlung im Vakuum (Druck kleiner 5*10³ Pa, Rohr-Laborofen der Fa. Linn Elektro Therm, Zeitdauer 2h) unterzogen. Zur Charakterisierung des kristallinen Phasenbestandes werden diese Proben mittels Röntgen-Diffraktometrie (Meßgerät: Röntgen-Diffraktometer URD-6 der Fa. Freiberger Präzisionsmechanik, Cu-Kα-Strahlung) untersucht. Dabei wird mit einem elektronischen Nachweissystem in Abhängigkeit vom Diffraktometer-Winkel 2θ die Intensität der von der Probe gestreuten Strahlung vermessen.

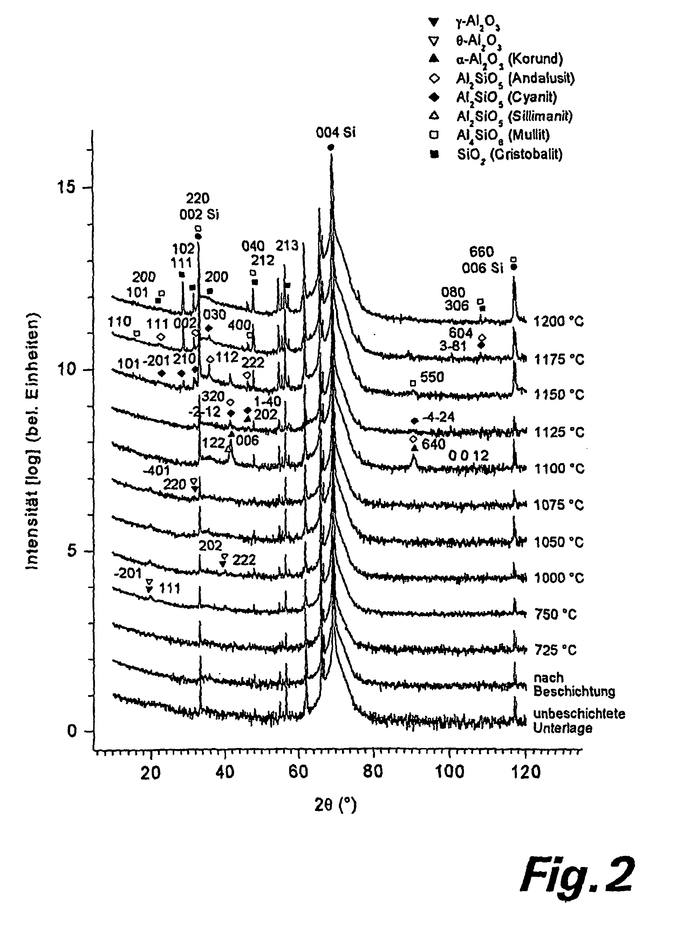

In **Fig. 2** sind Röntgen-Diffraktogramme der bei unterschiedlichen Temperaturen behandelten Proben dargestellt. Jedem Diffraktogramm ist die Temperatur zugeordnet, bei der die untersuchte Probe behandelt wurde. Reflexe treten beim Vorliegen einer kristallinen Ordnung auf, ihre Winkellage und auch Intensität ermöglicht Aussagen über die kristalline Struktur der untersuchten Materialien (durch Rechnung oder durch Vergleich mit Datensammlungen bekannter Strukturen).
Da die Schichten der Proben (Dicke ca. 70nm) bei der verwendeten symmetrischen Strahlgeometrie von der Röntgenstrahlung gut durchdrungen werden, ist in jedem Diffraktogramm der sehr starke Beitrag der Reflexe des einkristallinen Substrats (zum Vergleich ist das Diffraktogramm des unbeschichteten Substrats mit angegeben) zu erkennen. Die Folgen von 3 Ziffern in der Darstellung entsprechen Reflex-Indizierungen bezüglich der angegebenen kristallinen Phasen. Die beschichtete Probe ohne Temperatur- und Vakuumbehandlung weist keine zusätzlichen Reflexe der Schicht auf - die Schicht erscheint aus Sicht der Röntgen-Beugungsmessung strukturell amorph.

Bis zu einer Temperatur von 750 °C treten gegenüber dem unbeschichteten Substrat keine meßbaren Änderungen auf.

Das Einsetzen einer Kristallisation der Schichten wird nach einer Wärmebehandlung der Proben bei 750°C beobachtet. Die Reflexe können den Modifikationen γ-Al₂O₃ oder θ-Al₂O₃ zugeordnet werden. Bei der bei 1100°C behandelten Probe erkennt man in dem zugeordneten Diffraktogramm Reflexe, welche der Korund-Modifikation des Aluminiumoxids oder auch den Kristallstrukturen der Al₂SiO₅-Gruppe zugeordnet werden können. Auch wenn eine eindeutige Zuordnung hier erschwert ist, weisen alle hier möglichen Strukturen eine hohe Härte und auch chemische Resistenz auf.

Die bei Temperaturen >1125 °C behandelten Proben haben eine deutlich geringere Intensität der Reflexe. Dies spricht für die geringe Breite des Temperaturintervalls für die optimale Bildung dieser Strukturen. Der Umstand, daß in der gewählten Meßgeometrie nur einzelne Reflexe der betreffenden Phasen identifiziert werden können, wird mit dem Vorliegen einer starken Fasertextur der kristallinen Schichtbereiche erklärt.

Wärmebehandlungen der Proben bei Temperaturen oberhalb von 1150°C führen zur verstärkten Bildung von Mullit (Al₄SiO₈). Diese Phase ist als Material für harte und chemisch resistente Hochtemperaturbeschichtungen außerordentlich interessant. Im vorliegenden Fall wird außer Mullit auch die Siliziumoxid-Modifikation Cristobalit beobachtet. Auch eine eventuelle Einbettung des Cristobalit in eine Mullitmatrix kann vorteilhaft im Hinblick auf die thermische und mechanische Standfestigkeit der Schicht sein (es ist bekannt, daß der Zusatz von Cristobalit zu Glasuren die Entstehung von Haarrissen verhindern kann). Wichtig für den praktischen Einsatz ist, daß die erforderlichen Temperaturen der Wärmebehandlung unterhalb der Entglasungstemperatur einer Reihe wichtiger Gläser liegen womit eine unerwünschte Veränderung der Eigenschaften dieser Substrate verhindert werden kann.

Untersucht man die Beschaffenheit der Grenzfläche zwischen Beschichtung und Substrat mittels Röntgen-Reflektometrie beobachtet man bei Wärmebehandlung bis 1075°C noch eine ausgezeichnete Grenzfläche zwischen Beschichtung und Substrat, was auf einen scharfen Sprung der Konzentration der Komponenten von Schicht und Substrat hinweist. Grundlage für die Methode der Röntgen-Reflektometrie bildet die Interferenz von Teilstrahlen eines unter kleinen Winkeln auf die Oberfläche der Schicht (~ 1°) gerichteten Röntgenstrahls, die durch teilweise Reflexion an der Luft-Schicht-Grenzfläche bzw. der Grenzfläche Schicht-Substrat entstehen. Aus den winkelabhängig vermessenen Interferenzbildern kann dann u.a. auf die Dicke der Schicht und die Qualität der benannten Grenzflächen bzw. auch Grenzschichten geschlossen werden.

Werden Proben bei Temperaturen ab 1100°C behandelt, finden sich mit der Methode der Röntgen-Reflektometrie keine Hinweise mehr auf eine scharf lokalisierte Grenzfläche. Ersichtlich ist mit dieser Methode eine ausgedehnte Durchmischungszone mit einem Konzentrationsgradienten.

### Ausführungsbeispiel 2:

Auf Unterlagen aus Silikatglas wird durch reaktive Magnetron-Ionenstrahlzerstäubung eines Aluminiumoxid-Targets in einem Plasma, das Argon und Sauerstoff enthält, eine Schicht aus Aluminiumoxid abgeschieden (zur Methode s. z.B. *T.C. Chou* et al. - vollständiges Zitat weiter oben im Text der Beschreibung).

Die deponierten Schichten und Substrate werden zur Ausbildung der angestrebten kristallinen Modifikationen der Al₂SiO₅ - Gruppe unter den im Anwendungsbeispiel 1 genannten Bedingungen für Vakuum und Temperatur einer Wärmebehandlung unterworfen.

Die Untersuchung der Proben mittels Röntgen-Diffraktometrie und Röntgenreflektometrie erbringt mit Ausführungsbeispiel 1 vergleichbare Versuchsergebnisse. Die im Bereich der dort angegebenen Temperaturen behandelten Proben weisen ebenfalls die angestrebten harten Modifikationen auf. Während im allgemeinen die für das Abscheideverfahren und die Abscheidebedingungen charakteristische Realstruktur der Schichten und die Beschaffenheit der Grenzfläche Einfluß auf anschließende thermisch stimulierte Festkörperreaktionen haben, sind auch bei Wahl von Silikatglas als Unterlage für die beiden für industrietechnische Anwendungen bedeutsamen Verfahren der beiden Ausführungsbeispiele keine signifikanten Unterschiede erkennbar.

## Patentansprüche

1. Bauteile mit kristallinen Beschichtungen des Systems Aluminiumoxid/ Siliziumoxid, bei denen die kristalline Aluminiumsilikatbeschichtung mit der Unterlage aus Silizium oder Silikatglas verwachsen ist und eine Durchmischungszone mit einem Konzentrations- und/oder Strukturgradienten aufweist, erhältlich dadurch**,** daß bei oder nach der Aufbringung von Aluminiumoxidschichten auf Substraten aus Silizium oder Silikatglas eine Wärmebehandlung der Reaktionszone unter Vakuumbedingungen bei einem Druck kleiner 5x10³ Pa bei Temperaturen größer 1100 °C erfolgt.

2. Verfahren zur Erzeugung einer kristallinen Beschichtung des Systems Aluminiumoxid/Siliziumoxid, **dadurch gekennzeichnet, daß** bei oder nach der Aufbringung von Aluminiumoxidschichten auf Substraten aus Silizium oder Silikatglas eine Wärmebehandlung der Reaktionszone unter Vakuumbedingungen bei einem Druck kleiner 5x10³ Pa bei Temperaturen größer 1100 °C erfolgt.

3. Verfahren nach Anspruch 2, **dadurch gekennzeichnet, daß** die Wärmebehandlung durch Erwärmung der Aluminiumoxidschichten mittels elektromagnetischer Strahlung unter Vermeidung einer signifikanten Substraterwärmung erfolgt.

4. Verfahren nach Anspruch 3, **dadurch gekennzeichnet, daß** als elektromagnetische Strahlung Laserstrahlung eingesetzt wird.

5. Verfahren nach Anspruch 4, **dadurch gekennzeichnet, daß** die Wellenlänge der Laserstrahlung im UV-Bereich liegt.

6. Verfahren nach Anspruch 4 oder 5, **dadurch gekennzeichnet, daß** die Laserstrahlung streifend, nahezu parallel zur Substratoberfläche eingestrahlt und die Eindringtiefe in die Substratunterlage limitiert wird.

7. Verfahren nach Anspruch 2, **dadurch gekennzeichnet, daß** während der Aufbringung der Aluminiumoxidschichten die Substratunterlage beheizt oder mit elektromagnetischer Strahlung geeigneter Wellenlänge lokal erwärmt wird.

## Claims

1. Components having crystalline coatings of the aluminum oxide/silicon oxide system, whereby the crystalline aluminosilicate coating is intergrown with the silicon substrate or the silicate glass substrate, having an intermixture zone with a concentration and/or structure gradient, the coatings obtainable by that during applying or after having applied aluminum oxide coatings onto silicon or silicate glass substrates heat treatment of the reaction zone is carried out under vacuum conditions at a pressure less 5 x 10³ Pa at temperatures higher than 1100°C.

2. Method for the production of a crystalline coating of the aluminum oxide/silicon oxide system **characterized by** that during applying or after having applied aluminum oxide coatings onto silicon or silicate glass substrates heat treatment of the reaction zone is carried out under vacuum conditions at a pressure less 5 x 10³ Pa at temperatures higher than 1100°C.

3. Method to claim 2 **characterized by** that the heat treatment is carried out by heating the aluminum oxide coatings using electromagnetic radiation while avoiding significant substrate heating.

4. Method to claim 3 **characterized by** that laser radiation is used as the electromagnetic radiation.

5. Method to claim 4 **characterized by** that the wavelength of the laser radiation is in the UV-range.

6. Method to claim 4 or 5 **characterized by** that the laser radiation is applied grazing, nearly parallel to the substrate surface, the depth of penetration into the substrate base being limited.

7. Method to claim 2 **characterized by** that when the aluminum oxide coatings are being applied the substrate base is heated or locally heated using electromagnetic radiation of a suitable wavelength.

## Revendications

1. Éléments de construction ou composants pourvus de revêtements cristallins du système oxyde d'aluminium/oxyde de silicium, dans lesquels le revêtement cristallin de silicate d'aluminium est imbriqué avec la base ou le support en silicium ou en verre de silice et présente une zone de mélange ayant un gradient de concentration et/ou de structure, pouvant être obtenus en ce que lors de ou après l'application des couches d'oxyde d'aluminium sur des substrats en silicium ou en verre de silice, on réalise un traitement thermique de la zone de réaction dans des conditions de vide, à une pression inférieure à 5 x 10³ Pa et à des températures supérieures à 1100 °C.

2. Procédé de génération d'un revêtement cristallin du système oxyde d'aluminium/oxyde de silicium, **caractérisé en ce que**, lors de ou après l'application de couches d'oxyde d'aluminium sur des substrats en silicium ou en verre de silice, on réalise un traitement thermique de la zone de réaction dans des conditions de vide, à une pression inférieure à 5 x 10³ Pa et à des températures supérieures à 1100 °C.

3. Procédé selon la revendication 2, **caractérisé en ce que** le traitement thermique est réalisé par échauffement des couches d'oxyde d'aluminium au moyen d'un rayonnement électromagnétique en évitant un échauffement significatif du substrat.

4. Procédé selon la revendication 3, **caractérisé en ce que** l'on utilise en tant que rayonnement électromagnétique un rayonnement laser.

5. Procédé selon la revendication 4, **caractérisé en ce que** la longueur d'onde du rayonnement laser se situe dans la gamme des UV.

6. Procédé selon la revendication 4 ou 5, **caractérisé en ce que** le rayonnement laser est irradié de façon effleurante, presque parallèlement à la surface du substrat, et **en ce que** la profondeur de pénétration dans la base ou le support du substrat est limitée.

7. Procédé selon la revendication 2, **caractérisé en ce que**, pendant l'application des couches d'oxyde d'aluminium, la base ou le support du substrat est chauffé ou localement échauffé avec un rayonnement électromagnétique de longueur d'onde appropriée.
